# FASCICULE DE BREVET EUROPEEN

(11) **EP 2 184 769 B1**
(45) Date de publication et mention de la délivrance du brevet: **24.08.2016**
(21) Numéro de dépôt: 09174878.0
(22) Date de dépôt: 03.11.2009
(51) Int. Cl.: H01L 21/285, H01L 21/336, H01L 21/28, H01L 27/06, H01L 29/66, H01L 21/78, H01L 21/822, H01L 29/78

(54) **Procédé de préparation d'une couche comprenant du monosiliciure de nickel NiSi sur un substrat comprenant du silicium**
Verfahren zur Herstellung einer Schicht, die Nickel-Monosilizium (NiSi) umfasst, auf einem Substrat, das Silizium enthält
Method for preparing a layer comprising a nickel monosilicide NiSi on a substrate containing silicon

(30) Priorité: 07.11.2008 FR 0857581
(43) Date de publication de la demande: 12.05.2010
(73) Titulaire: Commissariat à l'Énergie Atomique et aux Énergies Alternatives, 75015 Paris (FR)
(72) Inventeur: Nemouchi, Fabrice, 38430, Moirans (FR); Carron, Véronique, 38640, Claix (FR)
(74) Mandataire: Ilgart, Jean-Christophe

(56) Documents cités:
- US-A1- 2005 202 663
- US-A1- 2005 250 319
- US-A1- 2007 004 205

## Description

### DOMAINE TECHNIQUE

La présente invention a trait à un procédé de préparation d'une couche comprenant du monosiliciure de nickel NiSi sur un substrat comprenant du silicium appartenant, par exemple, à une structure semi-conductrice, cette couche comprenant du monosiliciure de nickel NiSi présentant une stabilité de phases à haute température (par exemple, à des températures de l'ordre de 700°C), une stabilité morphologique de films et qui plus est, une résistivité faible.

Ce procédé trouve tout particulièrement son application dans la réalisation de dispositifs électroniques semi-conducteurs, tels que des transistors MOS comprenant des parties en silicium, et pour lequel une couche en siliciure est nécessaire pour notamment diminuer la résistance de contact entre les différentes parties en silicium, telles que la source et le drain d'un transistor MOS et assurer la connexion entre ses parties et les niveaux d'interconnexion.

Encore plus particulièrement, ce procédé peut trouver son application dans la réalisation de dispositifs électroniques semi-conducteurs, comportant un niveau inférieur de transistor comprenant une couche comprenant du monosiliciure de nickel obtenue par le procédé de l'invention et un niveau supérieur de transistor, tel que des transistors à base de germanium.

### ÉTAT DE LA TECHNIQUE ANTÉRIEURE

Comme mentionné précédemment, il peut être important d'incorporer dans des dispositifs semi-conducteurs à base de silicium une couche de siliciure destinée à limiter la résistance de contact entre les différentes parties du dispositif en silicium, telles que la source et le drain dans un transistor.

Les principaux siliciures utilisés dans ce type de contexte sont le disiliciure de titane TiSi₂, le disiliciure de cobalt CoSi₂ et le siliciure de nickel NiSi, la préférence portant sur le siliciure de nickel NiSi, notamment pour les technologies sub-65 nm du fait de sa plus faible température de formation par rapport aux autres siliciures, de sa faible résistivité et de la faible consommation de silicium requise pour le former.

Toutefois, le monosiliciure de nickel NiSi présente les inconvénients suivantes :
- une faible stabilité thermique, dans la mesure où, à une température proche de 600°C et à des températures supérieures, il s'ensuit un phénomène de démouillage entre la couche de NiSi et la zone en silicium sous-jacente (la couche de NiSi se transformant en agglomérats et perdant ainsi son caractère de film), et ainsi une dégradation importante du contact siliciure-silicium ;
- qui plus est, au-delà d'une température d'environ 750°C, il s'ensuit une transformation de phase du monosiliciure de nickel NiSi en disiliciure de nickel NiSi₂, cette dernière engendrant une augmentation de la résistivité de la couche et une dégradation de la qualité de contact entre la couche et les zones en Si sous-jacentes, du fait de la forte rugosité de surface entre la phase NiSi₂ nouvellement formée et les zones en silicium sous-jacentes.

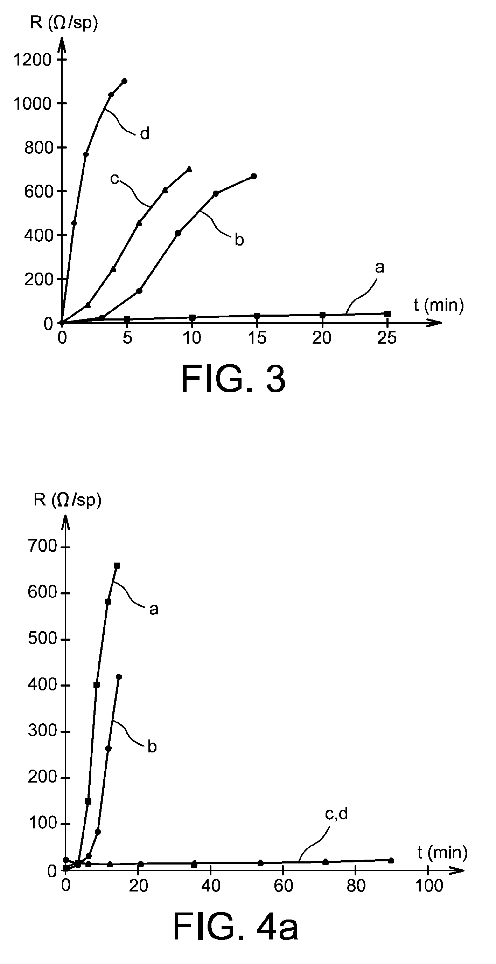

Comme il ressort de la figure 3 représentant un graphique illustrant la résistance de film R de NiSi (en Ω/carré symbolisé Ω/sq) en fonction du temps t (en min) appliqué pour différentes températures de recuit (respectivement 550°C pour la courbe a, 600°C pour la courbe b, 650°C pour la courbe c, et 700°C pour la courbe d), la résistance de film de NiSi augmente significativement pour des températures de recuit croissantes. Ainsi, le siliciure NiSi reste intègre après 25 minutes de traitement à 550°C, tandis qu'en moins de 2 minutes à 600°C, il s'ensuit une augmentation significative de la résistance de film. Cette augmentation de la résistance de film traduit un changement de morphologie du film (du fait d'un phénomène d'agglomération) et le film ne remplit ainsi plus son rôle de contact de faible résistivité pour toute température au-delà de 600°C. Il est donc exclu de pouvoir utiliser du monosiliciure de nickel NiSi dans une architecture qui nécessite des températures de traitement au-delà de 600°C.

Afin de palier les problèmes de démouillage de NiSi et retarder la formation de NiSi₂, diverses solutions ont été proposées consistant :
- soit en l'addition d'un élément d'alliage dans le nickel (lequel élément d'alliage étant soluble dans NiSi) ; et/ou
- soit en l'addition d'un élément non soluble dans le siliciure NiSi.

Ainsi, il a été montré par Mangelinck et al., dans Applied Physics Letters, 75(1999), 1736 et par Cheng et al. dans Journal of Vacuum Science Technology A 18 (2000), 1776 que l'addition d'un élément soluble tel le Pt, Pd et Rh, en particulier le platine Pt, permettait d'éviter la formation de NiSi₂, en particulier en deçà de 850°C pour Pt. Le platine Pt permet, notamment, de retarder la formation de NiSi₂ en favorisant la réaction entre NiSi et le silicium sous-jacent en augmentant ainsi la température de germination de NiSi₂. Outre son rôle sur le retard à la germination de NiSi₂, le platine agit également sur le retard à l'agglomération de NiSi. L'ajout de Pt dans NiSi augmente ainsi les paramètres de maille et modifie la texture du siliciure de manière à rendre la couche moins sensible au démouillage.

Il a été montré également par Detavernier et al., Electrochemical Society Transactions 3 (2006) 13 et Deduytsche et al., Journal of Applied Physics 101 (2007) que des éléments tels que le W, Ti, Ta, Mo, Cr permettent de retarder l'agglomération de NiSi (ou en d'autres termes, le démouillage du film de NiSi) vers des températures plus élevées qu'en l'absence de ces éléments, ces éléments incorporés se distribuant au niveau des joints de grains de NiSi lors de sa formation.

Toutefois en procédant à l'ajout des éléments susmentionnés, il s'ensuit généralement une augmentation de la résistivité du film de NiSi, ce qui est contre-productif dans la mesure où le but de ce type de film est, entre autres, de diminuer les résistances séries entre les éléments sous-jacents à ce film.

Ainsi, il subsiste un véritable besoin pour un procédé de fabrication d'une couche comprenant du monosiliciure de nickel NiSi à partir d'un substrat comprenant du silicium qui présente à la fois une stabilité de phase à haute température (c'est-à-dire sans transformation de phase de NiSi en NiSi₂) et une stabilité morphologique de film à haute température (c'est-à-dire sans phénomène de démouillage de film) tout en présentant une résistivité faible.

Le document US2005/250319 représente un autre état de la technique relevant.

### EXPOSÉ DE L'INVENTION

Les inventeurs ont ainsi découvert, de manière surprenante, un procédé comprenant une séquence d'étapes et des ingrédients qui permettent de répondre au besoin susmentionné.

L'invention a trait ainsi, selon un premier objet, à un procédé de fabrication d'une couche comprenant du monosiliciure de nickel NiSi sur un substrat comprenant du silicium comprenant successivement les étapes suivantes :
a) une étape d'incorporation, par implantation ionique, sur une partie de l'épaisseur dudit substrat comprenant du silicium d'un élément choisi parmi W, Ti, Ta, Mo, Cr et les mélanges de ceux-ci ;
b) une étape de dépôt sur ledit substrat obtenu à l'étape a) d'une couche de nickel et d'une couche d'un élément choisi parmi Pt, Pd, Rh et des mélanges de ceux-ci ou d'une couche comprenant à la fois du nickel et un élément choisi parmi Pt, Pd, Rh et des mélanges de ceux-ci ;
c) une étape de chauffage à une température efficace pour obtenir la formation d'une couche comprenant du siliciure de nickel éventuellement sous forme de monosiliciure de nickel NiSi ;
d) une étape d'incorporation de fluor dans ladite couche obtenue en c) ; et
e) éventuellement une étape de chauffage à une température efficace pour transformer la couche mentionnée en d) en une couche comprenant du siliciure de nickel intégralement sous forme de monosiliciure de nickel NiSi.

Ainsi, grâce à cette séquence d'étapes, l'on résout ainsi les problèmes liés à :
- la transformation de la couche comprenant du NiSi en agglomérats lorsque la couche est exposée à des températures élevées (par exemple, de l'ordre de 700°C) grâce notamment à la présence, dans la couche, d'un élément choisi parmi W, Ti, Ta, Mo et Cr) ;
- la transformation de NiSi en NiSi₂ lorsque la couche est exposée à des températures élevées (par exemple, de l'ordre de 700°C) grâce notamment à la présence, dans la couche, d'un élément décalant la température de germination de NiSi₂ vers des températures plus élevées que celles existant en l'absence d'un tel élément, cet élément étant choisi parmi Pt, Pd et Rh et les mélanges de ceux-ci ;
- l'augmentation de résistance de la couche du fait de l'incorporation des deux types d'éléments susmentionnés, grâce à l'ajout d'un élément (en particulier, le fluor) permettant de compenser une telle augmentation de résistance.

Il importe que la séquence d'étapes du procédé susmentionné soit respectée de sorte à ce que les effets de chacun des éléments mentionnés ci-dessus soient remplis.

Il ne pouvait être déduit d'emblée que l'introduction dans NiSi des espèces susmentionnées puissent conférer les avantages mentionnés ci-dessus. En effet, le comportement de plusieurs espèces, en quantité minoritaire, dans un système reste difficile à prévoir, car l'introduction d'espèces dans un système modifie l'équilibre thermodynamique de celui-ci. A titre d'exemple, ce phénomène est très bien illustré par l'expérience de Darken, dans laquelle une même quantité de carbone est initialement présente dans les deux phases du couple Fe(C)/FeSi(C). Alors que le système semble être à l'équilibre, le carbone se redistribue de façon non uniforme entre les deux phases en raison de la présence de silicium.

Ainsi la première étape du procédé consiste à incorporer sur une partie de l'épaisseur d'un substrat comprenant du silicium un élément choisi parmi W, Ti, Ta, Mo, Cr et les mélanges de ceux-ci.

Par substrat comprenant du silicium, on entend un substrat comprenant des zones en silicium, cela n'excluant pas le fait que ce substrat puisse contenir des zones qui ne soient pas en silicium, tel que des zones isolantes, par exemple en oxyde de silicium.

Le substrat comprenant du silicium peut correspondre, par exemple, lorsque le procédé est mis en oeuvre dans le cadre de réalisation d'un transistor MOS, au canal, à la source et/ou au drain dudit transistor, qui sont tous en silicium.

L'étape d'incorporation de l'élément susmentionné a) se fait par implantation ionique.

De façon pratique, dans le cas de l'implantation ionique, l'on soumet le substrat comprenant du silicium à un faisceau d'ions d'un élément choisi parmi W, Ti, Ta, Mo, Cr et les mélanges de ceux-ci de sorte à ce que les éléments pénètrent dans l'épaisseur du substrat comprenant du silicium. Par cette technique, il est possible de régler la quantité d'éléments à incorporer dans l'épaisseur du substrat comprenant du silicium en réglant le courant d'ions ainsi que la profondeur de pénétration desdits ions dans l'épaisseur dudit substrat en réglant la tension d'accélération.

L'énergie d'implantation sera réglée en fonction de l'élément que l'on souhaite implanter et l'épaisseur de silicium que l'on souhaite traiter. A titre d'exemple, la dose sera fixée de 5.10¹³ at/cm² à 1.10¹⁵ at/cm² pour une épaisseur de 20 nm à implanter.

Typiquement, l'épaisseur du substrat comprenant du silicium sur laquelle doit être incorporé l'élément susmentionné est celle correspondant à l'épaisseur de couche comprenant du monosiliciure de nickel SiNi que l'on souhaite obtenir, cette épaisseur pouvant aller classiquement de 10 nm à 40 nm.

La teneur en élément est choisie classiquement de sorte à éviter tout démouillage du siliciure formé par rapport au silicium, cette teneur ne devant toutefois pas être trop importante pour ne pas trop dégrader la résistivité du monosiliciure de nickel NiSi qui sera formé et sa résistance de contact avec le silicium sous-jacent.

L'élément incorporé dans la première étape a) sera présent avantageusement en une teneur allant de 0,05% à 1% atomique par rapport au nombre total d'atomes de silicium du substrat.

Avantageusement, l'élément incorporé dans la première étape est l'élément tungstène.

Une fois l'étape a) réalisée, le procédé de l'invention peut comprendre, avant la mise en oeuvre de l'étape de dépôt b), une étape de nettoyage de la surface du substrat. Le but du nettoyage est d'enlever l'oxyde de silicium SiO₂, qui recouvre, le cas échéant, la surface de silicium, la présence de cet oxyde étant susceptible de bloquer la siliciuration. Il peut s'agir soit d'un oxyde natif soit d'un oxyde déposé avant les étapes d'implantation ionique.

Après l'éventuelle étape de nettoyage ou lorsque le nettoyage n'est pas nécessaire, après l'étape d'incorporation a), le procédé de l'invention comprend une étape de dépôt, sur ledit substrat obtenu en a), d'une couche de nickel et d'une couche d'un élément choisi parmi Pt, Pd, Rh et des mélanges de ceux-ci ou d'une couche comprenant à la fois du nickel et un élément choisi parmi Pt, Pd, Rh et des mélanges de ceux-ci.

L'élément nickel est l'élément qui est destiné à entrer dans la constitution du siliciure de nickel NiSi.

L'élément choisi parmi Pt, Pd, Rh et les mélanges de ceux-ci est destiné à stabiliser la phase NiSi lorsqu'elle sera formée, notamment à éviter d'une part la formation de NiSi₂ lorsque la couche comprenant du NiSi sera soumise à des températures élevées (telles qu'une température de 700°C), l'inconvénient de NiSi₂ étant à la fois de présenter une forte résistivité et de nécessiter une forte consommation de silicium (plus d'une fois et demi que NiSi) et d'autre part, l'agglomération de NiSi.

Que ce soit selon le mode où le dépôt se fait par le biais de deux couches distinctes ou le mode où le dépôt se fait par le biais d'une seule couche comprenant les deux éléments, l'élément Ni représentera avantageusement au moins 90% atomique(à savoir au moins 90% du total des atomes comprenant Ni, les éléments déposés Pd, Pt, Rh ou les mélanges de ceux-ci), tandis que l'élément choisi parmi Pd, Pt, Rh ou les mélanges de ceux-ci représentera avantageusement au plus 10% atomique par rapport au nombre total d'atomes (à savoir au plus 10% du total des atomes comprenant Ni, les éléments déposés Pd, Pt, Rh ou les mélanges de ceux-ci).

Le dépôt des deux couches ou d'une seule couche lorsque celle-ci comprend les deux éléments peut être effectué par tout type de techniques de dépôt de couche métallique.

A titre d'exemple, on peut citer :
- le dépôt chimique en phase vapeur (connue sous l'abréviation CVD) ;
- la pulvérisation cathodique ;
- l'évaporation sous faisceau d'électrons ;
- le dépôt par couche atomique (connu sous le nom de dépôt ALD) ;
- le dépôt electroless (c'est-à-dire sans apport de courant électrique).

Plus précisément, à titre d'exemple, lorsqu'il s'agit de déposer une seule couche, ce dépôt peut être effectué par pulvérisation d'une cible d'alliage comprenant du nickel et l'autre élément (à savoir, Pd, Pt, Rh ou les mélanges de ceux-ci) ou par co-pulvérisation simultanée de deux cibles distinctes : une cible en nickel et une cible de l'autre élément (à savoir, Pd, Pt, Rh ou les mélanges de ceux-ci).

A titre d'exemple, lorsqu'il s'agit de déposer de deux couches, ce dépôt peut être effectué par dépôt d'une couche en nickel suivi du dépôt d'une couche en l'autre élément (à savoir, Pd, Pt, Rh ou les mélanges de ceux-ci).

L'étape de dépôt sera réalisée, avantageusement, à une température inférieure à 100°C, en vue notamment d'éviter lors du dépôt la formation prématurée de siliciure.

L'épaisseur de la couche ou des couches peut aller de 1 nm à 100 nm, de préférence, de 5 à 20 nm.

Ensuite, le procédé de l'invention comprend une étape de chauffage à une température efficace afin que le nickel puisse réagir avec le silicium pour former un siliciure de nickel dont au moins une partie peut être du monosiliciure de nickel.

Sans être lié par la théorie, lors de cette étape, l'élément choisi parmi W, Ti, Ta, Mo, Cr et les mélanges de ceux-ci, peu soluble dans le siliciure en train de se former est repoussé au niveau des joints de grains du siliciure assurant ainsi, par effet mécanique, une meilleure tenue du siliciure. Au terme de ce premier traitement thermique, le siliciure formé peut être un mélange de NiSi et d'autres siliciures plus riches en nickel.

L'étape de chauffage peut être réalisée par un procédé thermique dit rapide (connu également par l'expression anglaise « Rapid Thermal Processing » et l'abréviation RTP).

Comme type particulier de procédé thermique dit rapide, on peut citer le recuit thermique sous lampe (correspondant à l'expression anglaise « lamp-based Rapid Thermal Annealing RTA), dont la durée de traitement est généralement de quelques dizaines de secondes à quelques minutes, un recuit de type spike RTA ou flash RTA. Ces recuits ultra-rapides correspondent à des durées de traitement de l'ordre de quelques secondes dans le cas du recuit du type « spike » à quelques millisecondes dans le cas du recuit du type « flash ».

Avantageusement, l'étape de chauffage est réalisée sous une atmosphère comprenant un gaz inerte, tel que l'argon Ar ou l'azote N₂.

Cette étape de chauffage peut être réalisée à une température allant de 200 à 600°C, par exemple pendant une durée allant de quelques fractions de secondes (notamment lorsque le chauffage est réalisé par recuit spike) à 10 minutes pour des épaisseurs de couches métalliques de 1 nm à 100 nm. Le plus souvent, l'épaisseur des couches métalliques varie de 5 nm à 15 nm, la température de 300 à 450°C et la durée de 30 secondes à 2 minutes.

A l'issue de cette étape de chauffage, l'on obtient ainsi une couche comprenant du siliciure de nickel éventuellement sous forme de monosiliciure de nickel NiSi et comprenant, en outre, un élément choisi parmi W, Ti, Ta, Mo, Cr et les mélanges de ceux-ci et un élément choisi parmi Pt, Pd, Rh et les mélanges de ceux-ci.

Sur le substrat sur lequel sont déposées les couches métalliques et lorsque ce substrat comporte des zones autres que des zones en silicium, telles que des zones diélectriques en oxyde métallique, il se peut qu'il subsiste, lorsque l'étape de chauffage est achevée, du métal n'ayant pas réagi sur lesdites zones autres que les zones en silicium.

Dans ce cas, le procédé de l'invention peut comporter une étape de retrait dudit métal desdites zones, cette étape de retrait pouvant consister à mettre en contact le substrat avec une solution apte à éliminer sélectivement le métal par rapport au siliciure formé.

A titre d'exemple, lorsque le substrat comporte des zones en silicium sur lequel une couche de siliciure de nickel a été formée et des zones en silice recouvertes d'une couche métallique (Pd+Ni) n'ayant pas réagi, l'étape de retrait peut consister à mettre en contact le substrat avec une solution permettant de graver sélectivement le métal par rapport au siliciure. Dans le cas du nickel, on utilise généralement un mélange H₂SO₄/H₂O₂/H₂O.

Une fois le siliciure formé lors de l'étape de chauffage susmentionnée, le procédé de l'invention comprend une étape d'incorporation de fluor dans la couche comprenant du siliciure de nickel obtenue à l'étape c).

Cet élément fluor est important pour compenser l'altération de la résistivité et de la résistance de contact générée par l'addition des éléments métalliques, tels que W et Pt.

L'adjonction de fluor dans la couche de siliciure présente un double effet :
- une diminution de la résistivité du siliciure de nickel NiSi formé ;
- une stabilisation du NiSi formé.

Cette étape d'incorporation est réalisée classiquement par implantation ionique de fluor.

Avantageusement, la quantité intégrale de fluor implanté doit être contenue dans la couche de siliciure. Ainsi, l'énergie d'implantation sera fixée de telle sorte à ce que le fluor soit cantonné uniquement dans la couche de siliciure. La dose d'implantation peut être dans la gamme allant de 1.10¹³ à 1.10¹⁵ at.cm².

A l'issue de cette étape d), l'on obtient ainsi une couche comprenant du siliciure de nickel éventuellement sous forme de monosiliciure de nickel NiSi et comprenant, en outre, du fluor, un élément choisi parmi W, Ti, Ta, Mo, Cr et les mélanges de ceux-ci et un élément choisi parmi Pt, Pd, Rh et les mélanges de ceux-ci.

Enfin, le procédé de l'invention peut comprendre, lorsque la première étape de chauffage n'a pas été suffisante pour transformer le siliciure de nickel présent dans la couche intégralement en monosiliciure de nickel NiSi, une seconde étape de chauffage, à une température de chauffage efficace pour transformer l'intégralité du siliciure de nickel présent dans la couche obtenue à l'étape d) en monosiliciure de nickel NiSi.

Qui plus est, cette étape de chauffage peut contribuer à supprimer les défauts générés par l'implantation de fluor (tels qu'une amorphisation), lors de l'étape précédente et à distribuer uniformément le fluor dans la couche de siliciure.

Comme pour la première étape de chauffage, l'étape de chauffage peut être réalisée par un procédé thermique dit rapide (connu également par l'expression anglaise « Rapid Thermal Processing » et l'abréviation RTP).

Comme type particulier de procédé thermique dit rapide, on peut citer le recuit thermique sous lampe (correspondant à l'expression anglaise « lamp-based Rapid Thermal Annealing RTA) ou un recuit spike, tels que décrits ci-dessus pour la première étape de chauffage. Avantageusement, l'étape de chauffage est réalisée sous une atmosphère comprenant un gaz inerte, tel que l'argon Ar ou l'azote N₂.

Cette étape de chauffage peut être réalisée à une température allant de 350°C à 600°C, par exemple pendant une durée allant de quelques fractions de secondes (notamment lorsque le chauffage est réalisé par recuit spike) à 10 minutes pour des épaisseurs de couches métalliques de 1 nm à 100 nm. Le plus souvent, l'épaisseur des couches métalliques varie de 5 nm à 15 nm, la température de 300 à 450°C et la durée de 30 secondes à 2 minutes. Généralement, la température appliquée lors de cette seconde étape de chauffage sera supérieure à celle appliquée lors de la première étape.

L'invention a aussi trait à une couche comprenant du monosiliciure de nickel NiSi sur un substrat comprenant du silicium susceptible d'être obtenue par un procédé tel que défini précédemment, ladite couche comprenant, en outre :
- un élément choisi parmi W, Ti, Ta, Mo, Cr et les mélanges de ceux-ci ;
- un élément choisi parmi Pd, Pt, Rh et les mélanges de ceux-ci ; et
- du fluor ;
cette couche pouvant présenter une épaisseur allant de 10 nm à 40 nm.

L'élément choisi parmi W, Ti, Ta, Mo, Cr et les mélanges de ceux-ci est présent, avantageusement en une teneur allant de 0,05 à 1% atomique par rapport au nombre total d'atomes de Si du substrat.

Avantageusement, le nickel du monosiliciure de nickel représente au moins 90% atomique du total des atomes de nickel et des éléments choisis parmi Pd, Pt, Rh et les mélanges de ceux-ci.

D'autres éléments caractéristiques des couches déjà décrits dans le cadre du procédé de réalisation sont également valables dans ce cas de figure.

Comme annoncé précédemment, les couches comprenant du monosiliciure de nickel NiSi obtenues selon le procédé de l'invention revêtent des zones en silicium et peuvent ainsi trouver leur application dans des dispositifs électroniques, tels que des dispositifs électroniques comportant des zones semi-conductrices en silicium, tels que les transistors MOS.

Ainsi, l'invention peut avoir trait à un procédé de fabrication d'un dispositif électronique comprenant successivement :
- une étape de réalisation des éléments constitutifs dudit dispositif, l'un au moins desdits éléments constitutifs étant en silicium ;
- une étape de dépôt sur chaque élément constitutif en silicium d'une couche comprenant du monosiliciure de nickel, laquelle est obtenue par la mise en oeuvre du procédé tel que défini ci-dessus.

Le dispositif électronique peut être un transistor MOS comportant des éléments constitutifs en silicium, tel que le drain, la source, la grille.

L'invention a trait également à un dispositif électronique comprenant au moins un élément constitutif en silicium, ledit élément étant recouvert d'une couche comprenant du monosiliciure de nickel NiSi susceptible d'être obtenue par un procédé tel que défini ci-dessus, ladite couche comprenant, en outre :
- un élément choisi parmi W, Ti, Ta, Mo, Cr et les mélanges de ceux-ci ;
- un élément choisi parmi Pd, Pt, Rh et les mélanges de ceux-ci ; et
- du fluor,
ce dispositif pouvant être un transistor MOS, auquel cas les éléments constitutifs en silicium recouverts d'une couche comprenant du monosiliciure de nickel NiSi telle que définie ci-dessous sont la source, le drain et la grille.

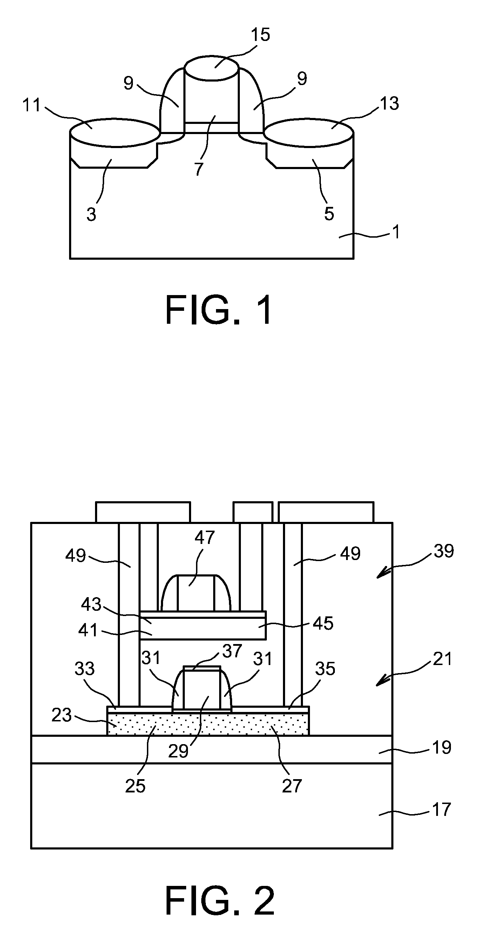

Un exemple de transistor est représenté sur la figure 1, comprenant respectivement :
- un substrat en silicium 1 ;
- une source et un drain respectivement numérotés 3 et 5 ;
- une grille 7 ;
- des espaceurs 9 ;
- des couches comprenant du monosiliciure de nickel déposées respectivement sur la source, le drain et la grille, lesdites couches étant numérotées respectivement 11, 13 et 15.

Du fait des caractéristiques des couches comprenant du monosiliciure de nickel obtenues par le procédé de l'invention, le procédé de l'invention peut être mis en oeuvre dans le cadre de dispositifs plus complexes, tels que des dispositifs comportant plusieurs niveaux de composants électroniques, tels que des composants transistor MOS.

Ainsi l'invention a trait aussi à un circuit intégré tridimensionnel de type MOS comprenant :
* un premier niveau comportant au moins un transistor de type n-MOS formé dans une couche semi-conductrice en silicium ;
* des couches comprenant du monosiliciure de nickel NiSi sur les parties en silicium dudit transistor, lesdites parties étant la source, le drain et la grille, lesdites couches comprenant du monosiliciure de nickel NiSi étant susceptibles d'être obtenues par un procédé tel que défini précédemment, lesdites couches comprenant, en outre :
   - un élément choisi parmi W, Ti, Ta, Mo, Cr et les mélanges de ceux-ci ;
   - un élément choisi parmi Pd, Pt, Rh et des mélanges de ceux-ci ; et
   - du fluor ; et
* un second niveau sur ledit premier niveau comprenant une couche semi-conductrice en germanium comprenant au moins un transistor de type p-MOS.

Un exemple de tel circuit est représenté sur la figure 2, ce circuit comprenant :
- un substrat en silicium 17 ;
- un couche d'oxyde enterré 19 déposée sur une face dudit substrat ;
- un niveau inférieur 21 comprenant un transistor MOS comprenant respectivement un substrat en silicium orienté (001) 23, une source et un drain respectivement numérotés 25 et 27, une grille 29, des espaceurs 31 et des couches comprenant du monosiliciure de nickel déposées respectivement sur la source, le drain et la grille, lesdites couches étant numérotées respectivement 33, 35 et 37 ;
- un niveau supérieur 39 surmontant le niveau inférieur 21, ledit niveau supérieur comprenant un transistor MOS comprenant respectivement un substrat en germanium orienté (001) 41, une source, un drain et une grille respectivement numérotés 43, 45 et 47 ;
- des interconnections métalliques 49 reliant les deux niveaux.

Les couches comprenant du monosiliciure de nickel obtenues conformément au procédé de l'invention sont aptes à subir, sans dégradation, les budgets thermiques nécessaires à la réalisation du deuxième niveau (ou niveau supérieur). En effet, une fois le premier niveau (ou niveau inférieur) achevé, le monosiliciure de nickel présent sur les parties en silicium du premier niveau subit tous les traitements thermiques des différentes étapes permettant la réalisation du second niveau (telles que le dépôt épitaxié de germanium à au moins 650°C pendant au moins 5 minutes). Avec des couches comprenant du monosiliciure de nickel telles qu'obtenues avec les procédés de l'art antérieur, il s'ensuivait un démouillage de la couche de comprenant du monosiliciure de nickel et/ou la formation de NiSi₂, engendrant une augmentation de la résistivité et de la résistance de contact, ce qui dégradait considérablement les performances des transistors.

Enfin l'invention a trait aussi à un procédé de fabrication d'un circuit intégré tridimensionnel de type MOS tel que défini précédemment, à savoir comportant des transistors de conductivité différentes, lesdits transistors étant formés respectivement dans des première et seconde couches semi-conductrices superposées, comprenant successivement :
- une étape de fabrication d'un premier niveau comportant au moins un transistor de type n-MOS formé dans une couche semi-conductrice en silicium ;
- une étape de dépôt d'une couche comprenant du monosiliciure de nickel sur les parties en silicium dudit transistor, lesdites parties étant la source, le drain et la grille, ladite couche comprenant du monosiliciure de nickel étant obtenue par la mise en oeuvre du procédé tel que défini ci-dessus ;
- une étape de transfert sur le premier niveau d'une couche semi-conductrice en germanium, constituant ainsi un second niveau sur ledit premier niveau ;
- une étape de fabrication dans ledit second niveau d'au moins un transistor de type p-MOS dans la couche semi-conductrice en germanium.

Hormis l'étape de dépôt de la couche de siliciure, les étapes de procédé se déroulent d'une façon similaire à celles décrites dans FR 2 896 620, incorporée ici par référence.

Le premier niveau comporte des transistors de type n-MOS, formés dans une première couche semi-conductrice en silicium, celle-ci ayant, de préférence, une orientation adaptée à la fabrication de transistor de type n-MOS. Le premier niveau peut comporter une couche diélectrique déposée sur ledit transistor.

Le deuxième niveau déposé sur le premier niveau (entre lesquelles s'intercale, éventuellement, la couche diélectrique susmentionnée) comporte des transistors du type p-MOS formés dans une seconde couche semi-conductrice et recouverts, éventuellement, par une couche diélectrique. La seconde couche semi-conductrice est généralement en germanium ayant une orientation adaptée à la fabrication de transistor de type p-MOS.

Les transistors sont réalisés classiquement respectivement dans la couche de silicium pour les transistors n-MOS et dans la couche de germanium pour les transistors p-MOS.

Cette réalisation comporte les étapes suivantes :
- gravure de la couche de silicium ou germanium pour délimiter le canal du transistor ;
- réalisation de la source et du drain disposés de part et d'autre du canal et en contact électrique avec celui-ci ;
- dépôt d'une grille de contrôle disposée au-dessus du canal et séparée au moins de celui-ci par un diélectrique de contrôle et une grille flottante et, éventuellement un diélectrique tunnel ;

- réalisation d'espaceurs par dépôt de diélectrique, lesdits espaceurs flanquant les faces de l'empilement diélectrique tunnel-grille flottante-diélectrique de contrôle-grille de contrôle ;
- dopage par implantation ionique avec des dopants n (tels que As, P) pour les transistors n-MOS et avec des dopants p (tels que B) pour les transistors p-MOS.

L'étape de transfert de la couche semi-conductrice de germanium peut se faire par collage moléculaire et amincissement ou par le procédé Smart Cut® (implantation d'hydrogène, collage et détachement).

Lorsque les niveaux comportent plusieurs transistors, lesdits transistors sont reliés électriquement par l'intermédiaire de vias, qui peuvent être réalisés par gravure sèche. De même, les transistors appartenant à des niveaux différents peuvent être reliés électriquement par le biais de vias verticaux, qui, outre le fait d'interconnecter directement les parties à connecteur de deux transistors distincts, permettent aussi la connexion de ceux-ci à d'autres éléments du circuit le cas échéant, ces vias pouvant être réalisés par gravure sèche.

Comme mentionné ci-dessus, l'élément fluor contribue à abaisser la résistance de film de la couche comprenant du monosiliciure de nickel NiSi, laquelle est augmentée par la présence conjointe d'un élément choisi parmi W, Ti, Ta, Mo, Cr et les mélanges de ceux-ci et d'un élément choisi parmi Pd, Pt, Rh et des mélanges de ceux-ci.

C'est pourquoi l'invention a également trait à l'utilisation de l'élément fluor pour diminuer la résistance de film d'une couche comprenant du monosiliciure de nickel NiSi comprenant à la fois un élément choisi parmi W, Ti, Ta, Mo, Cr et les mélanges de ceux-ci et un élément choisi parmi Pd, Pt, Rh et les mélanges de ceux-ci.

L'invention va maintenant être décrite par rapport à l'exemple ci-dessous donné à titre illustratif et non limitatif.

### BRÈVE DESCRIPTION DES DESSINS

La figure 1 représente une vue en coupe d'un transistor MOS comprenant sur certaines parties de celui-ci une couche comprenant du monosiliciure de nickel obtenue par le procédé de l'invention.
La figure 2 représente une vue en coupe d'un dispositif comprenant un premier niveau comprenant un transistor n-MOS et comprenant un second niveau comprenant un transistor p-MOS.
La figure 3 est un graphique illustrant la résistance de film R de NiSi (en Ω/carré symbolisé Ω/sq) en fonction du temps t (en min) appliqué pour différentes températures de recuit (respectivement 550°C pour la courbe a, 600°C pour la courbe b, 650°C pour la courbe c, et 700°C pour la courbe d).
Les figures 4a et 4b sont des graphiques représentant l'évolution de la résistance de film R (en Ω/carré symbolisé Ω/sq) en fonction du temps t (en min) à 600°C pour différents films NiSi (courbes a), NiSi+F (courbes b), NiSi+W (courbes c) et NiSi+W+F (courbes d) .
Les figures 5a et 5b sont des graphiques représentant l'évolution de la résistance de film R (en Ω/carré symbolisé Ω/sq) en fonction du temps t (en min) à 650°C pour différents films :
   - NiSi (courbe a), NiSi+F (courbe b), NiSi+W (courbe c) et NiSi+W+F (courbe d) pour la figure 5a ;
   - Ni(Pt)Si (courbe a), W+Ni(Pt)Si (courbe b) et W+Ni(Pt)Si+F (courbe c) pour la figure 5b.

### EXPOSÉ DÉTAILLÉ DE MODES DE RÉALISATION PARTICULIERS

### EXEMPLE

Cet exemple illustre la préparation d'une couche comprenant du NiSi selon un mode de réalisation du procédé de l'invention, la préparation comprenant les étapes suivantes :
- dépôt d'une couche d'oxyde thermique sur une plaque de silicium, afin de limiter les effets des impacts ioniques de la dose de W à une épaisseur de 20 nm ;
- incorporation de tungstène W dans un substrat en silicium par implantation ionique à raison de 5.10¹⁴ at/cm² à une énergie de 60 keV, de sorte à circonscrire le tungstène sur une épaisseur sensiblement égale à 20 nm, ce qui correspond à une concentration inférieure à 0,5% atomique de W dans le silicium;
- le retrait de la couche d'oxyde thermique protecteur ;
- un dépôt successif sur le silicium d'une couche métallique par pulvérisation cathodique (PVD) de Ni et de Pt, la teneur de platine par rapport au nickel étant proche de 8% atomique;
- une étape de traitement thermique sous atmosphère contrôlée et inerte par RTA à une température proche de 450°C durant 60 secondes ;
- une incorporation de fluor par implantation dans le siliciure formé après traitement thermique, de sorte à ce que la dose de F soit de 1.10¹⁵ at/cm² à une énergie de 7 KeV, ce qui confine toute la dose de F dans la couche comprenant du siliciure de nickel ;
- une étape de traitement thermique à différentes températures (650°C et 700°C), les échantillons ainsi traités étant soumis ensuite à une mesure de résistance de film.

Les essais ont été réalisés en pleine plaque, préalablement implantées par du As, afin de simuler les conditions rencontrées dans le cadre d'un transistor n-MOS. Cette pré-implantation permet notamment de vérifier si des interactions non désirées se produisent entre le dopant (As) et les éléments additionnels, à savoir ici le Ni, le Pt et le F.

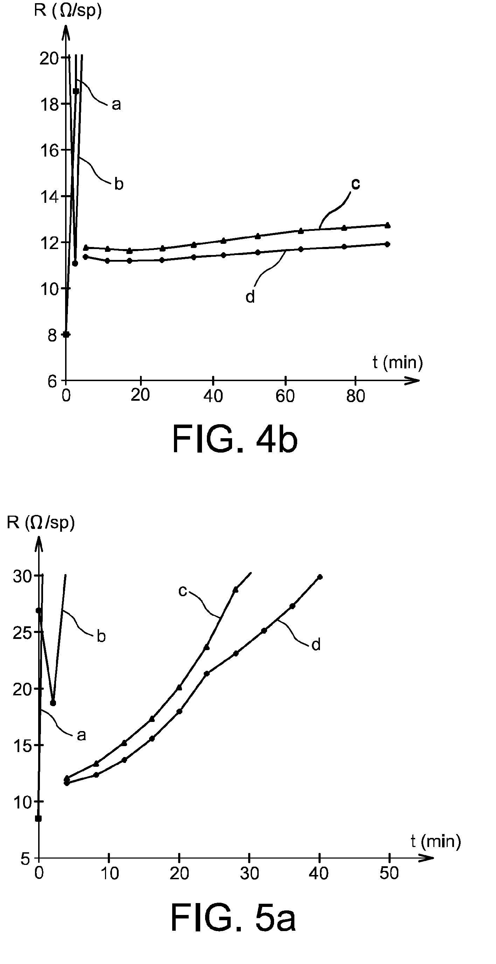

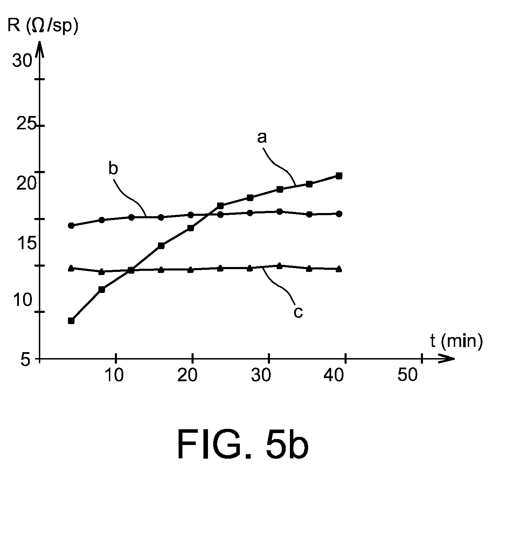

A titre comparatif, les mêmes mesures ont été réalisées pour des échantillons n'ayant subi qu'une implantation W et/ou F sans Pt dans Ni(figures 4a-4b et 5a) et avec présence de Pt dans Ni (figures 5b).

Ainsi, les figures 4a, 4b sont des graphiques représentant l'évolution de la résistance de film R (en Ω/carré) en fonction du temps t (en min) à 600°C pour différents films NiSi (courbes a), NiSi+F (courbes b), NiSi+W (courbes c) et NiSi+W+F (courbes d), la figure 4b représentant un zoom en ordonnée de la courbe 4a.

Les figures 5a et 5b sont des graphiques représentant l'évolution de la résistance de film R (en Ω/carré) en fonction du temps t (en min) à 650°C pour différents films :
- NiSi (courbe a), NiSi+F (courbe b), NiSi+W (courbe c) et NiSi+W+F (courbe d) pour la figure 5a ;
- Ni(Pt)Si (courbe a), W+Ni(Pt)Si (courbe b) et W+Ni(Pt)Si+F (courbe c).

De ces courbes, on peut déduire que l'élément W apporte une stabilité aux films dans lequel il est incorporé, lorsque ce film est soumis à des températures égales à 600°C, même après un recuit d'une heure et demi (voir courbes c pour figures 4a et 4b par rapport aux courbes a et b de ces mêmes figures). L'ajout combiné de W et Pt contribue à augmenter la résistance de film (à comparer la courbe a de la figure 5a à t=0 avec la courbe b de la figure 5b à t=0). F contribue à diminuer la résistance de film (voir courbes c et d de la figure 4b et courbes b et c de la figure 5b).

A 650°C (figure 5a), on peut constater une dégradation de la résistance de film, du fait que probablement le film NiSi s'agglomère et de la transformation d'une partie de NiSi en NiSi₂.

L'apport de platine devient donc nécessaire à partir de 650°C (figure 5b). L'effet cumulé de W et Pt stabilise NiSi (courbe b) mais la présence cumulée contribue à donner un film de résistance de film élevée. La présence de F contribue à abaisser la résistance de film à des valeurs attractives tout en conservant la stabilité de film induite par l'action combinée de W et Pt (courbe c).

## Revendications

1. Procédé de fabrication d'une couche comprenant du monosiliciure de nickel NiSi sur un substrat comprenant du silicium comprenant successivement les étapes suivantes :
a) une étape d'incorporation, par implantation ionique, sur une partie de l'épaisseur dudit substrat comprenant du silicium d'un élément choisi parmi W, Ti, Ta, Mo, Cr et les mélanges de ceux-ci ;
b) une étape de dépôt sur ledit substrat obtenu à l'étape a) d'une couche de nickel et d'une couche d'un élément choisi parmi Pt, Pd, Rh et des mélanges de ceux-ci ou d'une couche comprenant à la fois du nickel et un élément choisi parmi Pt, Pd, Rh et des mélanges de ceux-ci ;
c) une étape de chauffage à une température efficace pour obtenir la formation d'une couche comprenant du siliciure de nickel éventuellement sous forme de monosiliciure de nickel NiSi ;
d) une étape d'incorporation de fluor, par implantation ionique, dans ladite couche obtenue en c) ; et
e) éventuellement une étape de chauffage à une température efficace pour transformer la couche mentionnée en d) en une couche comprenant du siliciure de nickel intégralement sous forme de monosiliciure de nickel NiSi.

2. Procédé selon la revendication 1, dans lequel l'étape d'incorporation est réalisée sur une épaisseur du substrat allant de 10 nm à 40 nm.

3. Procédé selon l'une quelconque des revendications précédentes, dans lequel l'élément incorporé de l'étape a) est présent en une teneur allant de 0,05 à 1% atomique par rapport au nombre total d'atomes du silicium du substrat.

4. Procédé selon l'une quelconque des revendications précédentes, dans lequel l'élément incorporé dans l'étape a) est le tungstène.

5. Procédé selon l'une quelconque des revendications précédentes, dans lequel le nickel représente au moins 90% atomique du total des atomes de nickel et des éléments choisis parmi Pd, Pt, Rh et les mélanges de ceux-ci.

6. Procédé selon l'une quelconque des revendications précédentes, dans lequel l'étape b) est réalisée à une température inférieure à 100°C.

7. Procédé selon l'une quelconque des revendications précédentes, dans lequel l'étape de chauffage c) est réalisée à une température allant de 200 à 600°C.

8. Couche comprenant du monosiliciure de nickel NiSi sur un substrat comprenant du silicium susceptible d'être obtenue par un procédé tel que défini selon l'une quelconque des revendications 1 à 7, ladite couche comprenant, en outre :
- un élément choisi parmi W, Ti, Ta, Mo, Cr et les mélanges de ceux-ci ;
- un élément choisi parmi Pd, Pt, Rh et des mélanges de ceux-ci ; et
- du fluor.

9. Couche selon la revendication 8, dans lequel l'élément choisi parmi W, Ti, Ta, Mo, Cr et les mélanges de ceux-ci est présent en une teneur allant de 0,05 à 1% atomique par rapport au nombre total d'atomes de silicium du substrat.

10. Couche selon la revendication 8 ou 9, présentant une épaisseur allant de 10 nm à 40 nm.

11. Couche selon l'une quelconque des revendications 8 à 10, dans lequel le nickel du monosiliciure de nickel représente au moins 90% atomique du total des atomes de nickel et des éléments choisis parmi Pd, Pt, Rh et les mélanges de ceux-ci.

12. Procédé de fabrication d'un dispositif électronique comprenant successivement :
- une étape de réalisation des éléments constitutifs dudit dispositif, l'un au moins desdits éléments constitutifs étant en silicium ;
- une étape de dépôt sur chaque élément constitutif en silicium d'une couche comprenant du monosiliciure de nickel NiSi, laquelle est obtenue par la mise en oeuvre du procédé tel que selon l'une quelconque des revendications 1 à 7.

13. Procédé selon la revendication 12, dans lequel le dispositif est un transistor MOS.

14. Dispositif électronique comprenant au moins un élément constitutif en silicium, ledit élément étant recouvert d'une couche telle que définie à la revendication 8.

15. Dispositif électronique selon la revendication 14, qui est un transistor MOS, lesdits éléments constitutifs en silicium recouverts par une couche comprenant du monosiliciure de nickel telle que définie à la revendication 14 étant la source, le drain et la grille.

16. Procédé de fabrication d'un circuit intégré tridimensionnel de type MOS comportant des transistors de conductivité différentes, lesdits transistors étant formés respectivement dans des première et seconde couches semi-conductrices superposées, comprenant successivement :
- une étape de fabrication d'un premier niveau comportant au moins un transistor de type n-MOS formé dans une couche semi-conductrice en silicium ;
- une étape de dépôt d'une couche comprenant du monosiliciure de nickel sur les parties en silicium dudit transistor, lesdites parties étant la source, le drain et la grille, ladite couche comprenant du monosiliciure de nickel NiSi étant obtenue par la mise en oeuvre du procédé tel que défini selon l'une quelconque des revendications 1 à 7 ;
- une étape de transfert sur le premier niveau d'une couche semi-conductrice en germanium, constituant ainsi un second niveau sur ledit premier niveau ;
- une étape de fabrication dans ledit second niveau d'au moins un transistor de type p-MOS dans la couche semi-conductrice en germanium.

17. Circuit intégré tridimensionnel de type MOS comprenant :
* un premier niveau comportant au moins un transistor de type n-MOS formé dans une couche semi-conductrice en silicium ;
* des couches comprenant du monosiliciure de nickel NiSi sur les parties en silicium dudit transistor, lesdites parties étant la source, le drain et la grille, lesdites couches comprenant du monosiliciure de nickel NiSi étant telles que définies à la revendication 8 ; et
* un second niveau sur ledit premier niveau comprenant une couche semi-conductrice en germanium comprenant au moins un transistor de type p-MOS.

18. Utilisation de l'élément fluor pour diminuer la résistance de film d'une couche comprenant du monosiliciure de nickel NiSi comprenant à la fois un élément choisi parmi W, Ti, Ta, Mo, Cr et les mélanges de ceux-ci et un élément choisi parmi Pd, Pt, Rh et les mélanges de ceux-ci.

## Patentansprüche

1. Verfahren zur Herstellung einer Schicht, umfassend Monosilizid von Nickel, NiSi, auf einem Substrat, das Silicium umfasst, umfassend die folgenden aufeinanderfolgenden Schritte:
a) einen Schritt der Einlagerung durch ionische Implantation über einen Teil der Dicke des Substrats, das Silicium umfasst, eines Elements, ausgewählt aus W, Ti, Ta, Mo, Cr und Gemischen dieser;
b) einen Ablagerungsschritt auf dem in Schritt a) erhaltenen Substrat einer Schicht aus Nickel und einer Schicht aus einem Element, ausgewählt aus Pt, Pd, Rh und Gemischen dieser oder einer Schicht, gleichzeitig umfassend Nickel und ein Element, ausgewählt aus Pt, Pd, Rh und Gemische davon;
c) einen Schritt des Erwärmens bei einer Temperatur, die wirkungsvoll ist, um die Bildung einer Schicht zu erreichen, umfassend Nickelsilizid, gegebenenfalls in der Form von Nickelmonosilizid, NiSi;
d) einen Schritt der Einlagerung von Fluor durch ionische Implantation in die in Schritt c) erhaltene Schicht; und
e) gegebenenfalls einen Schritt des Erwärmens auf eine Temperatur, die wirkungsvoll ist, um die in Schritt d) erhaltene Schicht in eine Schicht überzuführen, die integral Nickelsilizid in der Form von Nickelmonosilizid, NiSi, umfasst.

2. Verfahren nach Anspruch 1, worin der Einlagerungsschritt über eine Dicke des Substrats von 10 nm bis 40 nm erfolgt.

3. Verfahren nach einem der vorhergehenden Ansprüche, worin das eingelagerte Element von Schritt a) in einer Menge von 0,05 bis 1 Atom-% bezüglich der Gesamtanzahl von Siliciumatomen des Substrats vorliegt.

4. Verfahren nach einem der vorhergehenden Ansprüche, worin das in Schritt a) eingelagerte Element Wolfram ist.

5. Verfahren nach einem der vorhergehenden Ansprüche, worin Nickel mindestens 90 Atom-% der gesamten Atome aus Nickel und den Elementen, ausgewählt aus Pd, Pt, Rh und den Gemischen dieser entspricht.

6. Verfahren nach einem der vorhergehenden Ansprüche, worin Schritt b) bei einer Temperatur unter 100 °C durchgeführt wird.

7. Verfahren nach einem der vorhergehenden Ansprüche, worin der Schritt des Erwärmens c) bei einer Temperatur von 200 bis 600 °C durchgeführt wird.

8. Schicht, umfassend Monosilizid von Nickel, NiSi, auf einem Substrat, umfassend Silicium, das durch ein Verfahren, wie in einem der Ansprüche 1 bis 7, erhalten werden kann, wobei die Schicht weiterhin umfasst:
- ein Element, ausgewählt aus W, Ti, Ta, Mo, Cr und Gemische dieser;
- ein Element, ausgewählt aus Pd, Pt, Rh und Gemische dieser; und Fluor.

9. Schicht nach Anspruch 8, worin das Element, das ausgewählt ist aus W, Ti, Ta, Mo, Cr und den Gemischen davon, in einer Menge von 0,05 bis 1 Atom-% bezüglich der Gesamtanzahl von Siliciumatomen des Substrats vorliegt.

10. Schicht nach Anspruch 8 oder 9, welche eine Dicke von 10 nm bis 40 nm aufweist.

11. Schicht nach einem der Ansprüche 8 bis 10, in welcher das Nickel des Monosilizids von Nickel mindestens 90 Atom-% der gesamten Atome von Nickel und der Elemente, ausgewählt aus Pd, Pt, Rh und den Gemischen davon, darstellt.

12. Verfahren zur Herstellung einer elektronischen Vorrichtung, aufeinanderfolgend umfassend:
- einen Schritt der Herstellung von Bestandteilen der Vorrichtung, worin zumindest einer der Bestandteile aus Silicium ist;
- einen Schritt der Ablagerung auf jedem Element aus Silicium einer Schicht, umfassend Nickelmonosilizid, NiSi, das erhalten wurde durch Durchführung des Verfahrens nach einem der Ansprüche 1 bis 7.

13. Verfahren nach Anspruch 12, worin die Vorrichtung ein MOS-Transistor ist.

14. Elektronische Vorrichtung, umfassend mindestens einen Bestandteil aus Silicium, wobei das Element beschichtet ist mit einer Schicht, wie in Anspruch 8 definiert.

15. Elektronische Vorrichtung nach Anspruch 14, welche ein MOS-Transistor ist, wobei die Bestandteile aus Silicium, die beschichtet sind durch eine Beschichtung, umfassend Monosilizid von Nickel, wie in Anspruch 14 definiert, die Quelle, der Drain und das Gate sind.

16. Verfahren zur Herstellung eines dreidimensionalen integrierten Schaltkreises des MOS-Typs, umfassend Transistoren mit verschiedener Leitfähigkeit, wobei die Transistoren jeweils gebildet werden in den ersten und zweiten übereinandergeschichteten ersten und zweiten halbleitenden Schichten, aufeinanderfolgend umfassend:
- einen Schritt der Herstellung einer ersten Ebene, umfassend mindestens einen Transistor des n-MOS-Typs, gebildet in einer Halbleiterschicht aus Silicium;
- einen Schritt der Ablagerung einer Schicht, umfassend Nickelmonosilizid, auf den Siliciumteilen des Transistors, wobei die Teile die Quelle, der Drain und das Gate sind, wobei die Beschichtung Nickelmonosilizid, NiSi umfasst, erhalten durch Anwendung des Verfahrens nach einem der Ansprüche 1 bis 7 ;
- einen Transferschritt einer Halbleiterschicht aus Germanium auf das erste Niveau die, sodass sich ein zweites Niveau über dem ersten Niveau bildet;
- einen Herstellungsschritt in dem zweiten Niveau mindestens eines Transistors des p-MOS-Typs in der Halbleiterschicht aus Germanium.

17. Dreidimensionaler integrierter Schaltkreis des MOS-Typs, umfassend:
- ein erstes Niveau, umfassend zumindest einen Transistor des n-MOS-Typs, gebildet in einer Halbleiter-Schicht aus Silicium;
- Schichten, umfassend Nickelmonosilizid, über den Teilen aus Silicium des Transistors, worin die Teile die Quelle, der Drain und das Gate sind, wobei die Schichten Nickelmonosilizid, NiSi, umfassen, die wie in Anspruch 8 beschrieben sind; und
- ein zweites Niveau über dem ersten Niveau, umfassend eine Halbleiter-Schicht aus Germanium, umfassend mindestens einen Transistor des p-MOS-Typs.

18. Verwendung des Elements Fluor zum Verringern des Widerstands eines Films aus einer Schicht, umfassend Nickelmonosilizid, NiSi, gleichzeitig umfassend ein Elements, ausgewählt aus W, Ti, Ta, Mo, Cr und den Gemischen dieser und ein Element, ausgewählt aus Pd, Pt, Rh und Gemischen davon.

## Claims

1. Method for fabricating a layer comprising nickel monosilicide NiSi on a substrate comprising silicon successively comprising the following steps:
a) a step of incorporating, by ionic implantation on a portion of the thickness of the said substrate comprising silicon, an element selected from W, Ti, Ta, Mo, Cr and mixtures thereof;
b) a step of depositing, on the said substrate obtained in step a), a layer of nickel and a layer of an element selected from Pt, Pd, Rh and mixtures thereof or a layer comprising both nickel and an element selected from Pt, Pd, Rh and mixtures thereof;
c) a step of heating to a temperature sufficient for obtaining the formation of a layer comprising nickel silicide optionally in the form of nickel monosilicide NiSi;
d) a step of incorporating fluorine by ionic implantation in the said layer obtained in c); and
e) optionally, a step of heating to a sufficient temperature to convert the layer mentioned in d) to a layer comprising nickel silicide entirely in the form of nickel monosilicide NiSi.

2. Method according to claim 1, in which the incorporation step is carried out on a thickness of the substrate of between 10 nm and 40 nm.

3. Method according to any one of the preceding claims, in which the element incorporated in step a) is present in a content of between 0.05 and 1 atomic % of the total number of silicon atoms of the substrate.

4. Method according to any one of the preceding claims, in which the element incorporated in step a) is tungsten.

5. Method according to any one of the preceding claims, in which nickel accounts for at least 90 atomic % of the total of the atoms of nickel and the elements selected from Pd, Pt, Rh and mixtures thereof.

6. Method according to any one of the preceding claims, in which step b) is carried out at a temperature below 100°C.

7. Method according to any one of the preceding claims, in which the heating step c) is carried out at a temperature of between 200 and 600°C.

8. Layer comprising nickel monosilicide NiSi on a substrate comprising silicon obtainable by a method as defined according to any one of Claims 1 to 7, the said layer further comprising:
- an element selected from W, Ti, Ta, Mo, Cr and mixtures thereof;
- an element selected from Pd, Pt, Rh and mixtures thereof; and
- fluorine.

9. Layer according to Claim 8, in which the element selected from W, Ti, Ta, Mo, Cr and mixtures thereof is present in a content of between 0.05 and 1 atomic % of the total number of silicon atoms of the substrate.

10. Layer according to claim 8 or 9 having a thickness of between 10 nm and 40 nm.

11. Layer according to any one of Claims 8 to 10, in which the nickel of the nickel monosilicide accounts for at least 90 atomic % of the total atoms of nickel and of the elements selected from Pd, Pt, Rh and mixtures thereof.

12. Method for fabricating an electronic device successively comprising:
- a step of preparing the constituent elements of the said device, at least one of the said constituent elements being in silicon;
- a step of depositing, on each silicon constituent element, a layer comprising nickel monosilicide NiSi, which is obtained by the implementation of the method according to any one of Claims 1 to 9.

13. Method according to Claim 12, in which the device is a MOS transistor.

14. Electronic device comprising at least one silicon constituent element, the said element being covered by a layer as defined in claim 8.

15. Electronic device according to claim 14, which is a MOS transistor, said silicon constituent elements covered by a lader comprising nickel monosilicide as defined in claim 14 being the source, the drain and the grid.

16. Method for fabricating a three-dimensional integrated circuit of the MOS type comprising transistors having different conductivities, the said transistors being formed respectively in the first and second superimposed semiconductor layers, successively comprising:
- a step of fabricating a first level comprising at least one n-MOS type transistor formed in a silicon semiconductor layer;
- a step of depositing a layer comprising nickel monosilicide on the silicon portions of the said transistor, the said portions being the source, the drain and the grid, the said layer comprising nickel monosilicide NiSi being obtained by the implementation of the method as defined according to any one of Claims 1 to 7;
- a step of transfer to the first level of a germanium semiconductor layer, thereby constituting a second level on the said first level;
- a step of fabricating in the said second level at least one p-MOS type transistor in the germanium semiconductor layer.

17. Three-dimensional integrated circuit of the MOS type comprising:
* a first level comprising at least one n-MOS type transistor formed in a silicon semiconductor layer;
* layers comprising nickel monosilicide NiSi on the silicon portions of the said transistor, the said portions being the source, the drain and the grid, the said layers comprising nickel monosilicide NiSi obtainable by a method as defined according to claim 8;
and
* a second level on the said first level comprising a germanium semiconductor layer comprising at least one p-MOS type transistor.

18. Use of the element fluorine to decrease the film resistance of a layer comprising nickel monosilicide NiSi comprising both an element selected from W, Ti, Ta, Mo, Cr and mixtures thereof and an element selected from Pd, Pt, Rh and mixtures thereof.
